# EUROPÄISCHE PATENTANMELDUNG

(11) **EP 0 735 375 A2**
(43) Veröffentlichungstag der Anmeldung: **02.10.1996**
(21) Anmeldenummer: 96104065.6
(22) Anmeldetag: 14.03.1996
(51) Int. Cl.: G01R 31/02

(54) **Vorrichtung zur Kabelbrucherkennung**

(30) Priorität: 30.03.1995 DE 29505412 U
(71) Anmelder: SIEMENS AKTIENGESELLSCHAFT, 80333 München (DE)
(72) Erfinder: Streichert, Gerhard, Dipl.-Ing. (FH), 92353 Postbauer-Heng (DE)

(57) **Zusammenfassung**

Die Vorrichtung enthält einen ersten Optokoppler (OK1) am Ende der Übertragungsstrecke (U), welcher die komplementären binären Übertragungssignale (A,/A) auf den beiden Leitungen (S1,S2) in ein binäres Empfangssignal (B) umsetzt, einen zweiten, relativ zum ersten Optokoppler (OK1) invers angeordneten Optokoppler (OK2) am Ende der Übertragungsstrecke (U), welcher die komplementären binären Übertragungssignale (A,/A) auf den beiden Leitungen (S1,S2) in ein inverses binäres Empfangssignal (/B) umsetzt, und ein Exklusiv-Oder Gatter (EX), dem das binäre und das inverse binäre Empfangssignal (B,/B) zur Bildung eines den Zustand der Leitungen (S1,S2) der Übertragungsstecke (U) kennzeichnenden Signals (F) zugeführt werden. Die Erfindung hat den Vorteil, daß eine Kabelbrucherkennung einerseits und eine die Störunempfindlichkeit der Signalübertragung ermöglichende Potentialtrennung am Ausgang der Übertragungsstrecke andererseits durch den Einsatz der beiden Optokoppler auf eine schaltungstechnisch einfache und dennoch außerordentlich wirksame Weise erreicht wird.

## Beschreibung

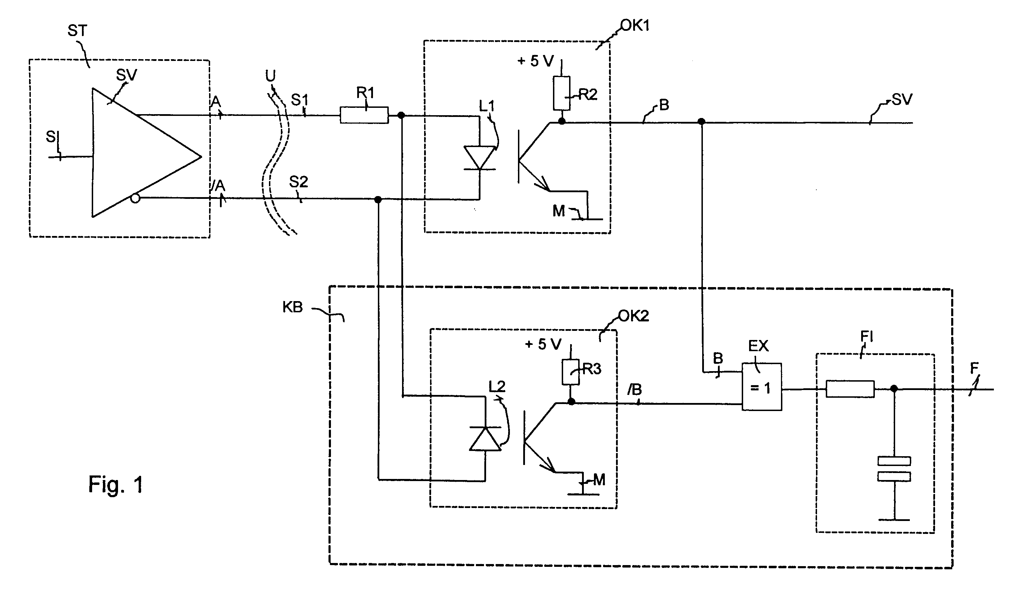

Die Übertragung von binären Informationen über das Kabel einer Übertragungsstrecke erfolgt in der Automatisierungstechnik häufig mit einem sogenannten 5-Volt-Pegel z.B. zu einem Automatisierungsgerät. Eine derartige Anordnung ist beispielhaft in der oberen Hälfte des Blockschaltbildes der Figur 1 dargestellt. Binäre Sendesignale SI, welche z.B. die einzelnen Bits eines seriell übertragenen Datenwortes sein können, werden von einem Signalverstärker SV am Ausgang einer Sendestation ST in Form eines binärer Übertragungssignale A in eine Übertragungsstrecke U eingespeist. Zur Verbesserung der Störunempfindlichkeit wird vorteilhaft eine sogenannte symmetrische Übertragung eingesetzt. Die Übertragungsstrecke U ist hierzu als eine Doppelkabelübertragungsstrecke mit den beiden Übertragungsleitungen S1,S2 ausgebildet. Diese übertragen das binäre Übertragungssignal A und ein dazugehöriges korrespondierendes, inverses Übertragungssignal /A.

Auf der Empfängerseite werden die Signale A,/A bevorzugt über einen zusätzlichen Strombegrenzungswiderstand R1 einem Optokoppler OK1 zugeführt. Dieser verfügt über eine erste Leuchtdiode L1, welche die erste Übertragungsleitung S1 mit der zweiten Übertragungsleitung S2 in Durchlaßrichtung verbindet. Die Leuchtdiode L1 wird durch den Bitstrom des Übertragungssignales A und des inversen Übertragungssignales /A angeregt. Der hierdurch entstehende Lichtbitstrom wird durch einen emitterseitig mit dem Massepotential M und kollektorseitig über einen Ankoppelwiderstand R2 mit der Versorgungsspannung + 5 Volt verbundenen Fototransistor in einer potentialtrennenden, die Störunempfindlichkeit verbessernden Weise in ein binäres Empfangssignal B umgewandelt. Dieses wird über eine Leitung SV zur üblichen Signalweiterverarbeitung z.B. einer speicherprogrammierbaren oder einer numerischen Steuerung zugeführt.

Ein unerwarteter Ausfall bei der Übertragung des Stroms binärer Signale SI durch eine mechanische Beschädigung der Übertragungsstrecke U kann insbesondere dann schwerwiegende Folgen haben, wenn der Bitstrom der in die Übertragungsstrecke U eingespeisten Übertragungssignale A,/A eine sogenannte Weginformation darstellt. Diese dient zum Erfassen der Istposition des Antriebs einer Maschine und wird von einem inkrementalen, an einer Welle der Maschine angebrachten z.B. rotatorischen Wegmeßgeber bereitgestellt. Wenn nun die Leitungen S1,S2 der Übertragungsstrecke U brechen, dann kann z.B. ein üblicherweise die Auswertung des binären Empfangssignales B über die Ansteuerleitung SV erledigendes Automatisierungsgerät die aktuelle Position des Antriebs nicht mehr erkennen. Dies kann schwerwiegende Fehler in der Maschine zur Folge haben, wenn nämlich z.B. ein vom Automatisierungsgerät angesteuerter Lageregler weiter versucht, die gewünschte Position anzufahren, obwohl sich die erfaßte Istposition nicht mehr ändert.

Der Erfindung liegt somit die Aufgabe zugrunde, eine Übertragungsstrecke der oben beschriebenen Art zum Schutz vor derartigen Fehlern um eine Vorrichtung zur Kabelbrucherkennung zu erweitern, ohne daß hierdurch das bereits bisher durch die Potentialtrennung erreichte hohe Maß an Übertragungssicherheit beeinträchtigt wird.

Die Aufgabe wird gelöst mit der im Anspruch 1 angegebenen Vorrichtung. Vorteilhafte weitere Ausgestaltungen der Erfindung sind in den Unteransprüchen enthalten.

Die erfindungsgemäße Schaltung hat den Vorteil, daß hiermit eine Kabelbrucherkennung einerseits und eine die Störungsempfindlichkeit der Signalübertragung erheblich verbessernde Potentialtrennung am Ausgang der Übertragungsstrecke andererseits durch den Einsatz der beiden Optokoppler auf eine schaltungstechnisch einfache aber dennoch außerordentlich wirksame Weise erreicht wird.

Die Erfindung wird mit den in den nachfolgend kurz angeführten Figuren dargestellten Beispielen weiter erläutert. Dabei zeigt
- Fig.1.: ein Blockschaltbild einer Übertragungsstrecke mit der erfindungsgemäßen Schaltung zur Kabelbruchüberwachung,
- Fig.2.: den Verlauf der Signale in der Schaltung von Figur 1 bei ungestörter Übertragungsstrecke,
- Fig.3.: den Verlauf der Signale in der Schaltung von Figur 1 bei Bruch einer der beiden Leitungen der Übertragungsstrecke, und
- Fig.4.: den Verlauf der Signale in der Schaltung von Figur 1 bei der Verbindung einer der beiden Leitungen der Übertragungsstrecke mit Masse.

Die Ergänzung der Übertragungsstrecke um die erfindungsgemäße Vorrichtung zur Kabelbruchüberwachung KB ist im unteren Bereich von Figur 1 in einem separaten strichliert umgebenen Bereich dargestellt.

Erfindungsgemäß werden die Übertragungsleitungen S1,S2 auf der Empfängerseite und damit die komplementären Übertragungssignale A,/A einem weiteren Optokoppler OK2 zugeführt. Dieser verfügt über eine zweite Leuchtdiode L2, welche aber im Vergleich zur Leuchtdiode L1 umgekehrt angeordnet ist und somit die zweite Übertragungsleitung S2 mit der ersten Übertragungsleitung S1 in Durchlaßrichtung verbindet. Die Leuchtdiode L2 wird ebenfalls durch den Bitstrom des Übertragungssignales A und des inversen Übertragungssignales /A angeregt. Der hierdurch entstehende Lichtbitstrom wird durch einen emitterseitig mit dem Massepotential M und kollektorseitig über einen Ankoppelwiderstand R3 mit der Versorgungsspannung + 5 Volt verbundenen weiteren Fototransistor in einer potentialtrennenden, die Störunempfindlichkeit verbessernden Weise in ein binäres, zum Empfangssignal B komplementäres Empfangssignal /B umgewandelt.

Mit dieser Antiparallelschaltung der beiden Leuchtdioden L1 und L2 in den beiden Optokopplern OK1, OK2 wird erreicht, daß diese im ungestörten Normalbetrieb immer wechselweise aufleuchten. Es muß immer genau eine der beiden Leuchtdioden aufleuchten, da die Signale B und /B an den Ausgängen der Optokoppler immer invers zueinander sind. Dies wird in der Kabelbruchüberwachung KB mit Hilfe eines logischen Exklusiv-Oder Gatters EX (EXOR) ausgewertet, indem diesem die Signale B, /B am Eingang zugeführt werden. Das Ausgangssignal F des Exklusiv-Oder Gatters EX, welches nachfolgend als Kabelzustandssignal bezeichnet werden soll, ist im ungestörten Normalbetrieb immer logisch '1'. Ist dieses Signalspiel aber durch eine mechanische Beschädigung der Übertragungsleitungen S1 und/oder S2 gestört, so zeigt eine logische '0' des Kabelzustandssignales F einen Fehler an.

Vorteilhaft ist dem Ausgang des Exklusiv-Oder Gatters EX noch ein aus einem Widerstand und einem Kondensator bestehendes Tiefpaßfilter FI nachgeschaltet. Hiermit kann ein mögliches kurzzeitiges Ansprechen des Exklusiv-Oder Gatters EX unterdrückt werden, welches bei einem Wechsel der Signale A, /A aufgrund von Unsymmetrien in den Optokopplern OK1, OK2 verursacht wird. Derartige Fehlimpulse werden über das nachgeschaltete Filter FI unterdrückt.

Mit Hilfe der erfindungsgemäßen Schaltung können folgende Fehlerarten der Übertragungsstrecke U erkannt werden:
1. Bruch einer Übertragungsleitung S1 oder S2,
2. Bruch beider Übertragungsleitungen S1 und S2,
3. Verbindung einer Übertragungsleitung S1 oder S2 mit dem Massepotential, und
4. Verbindung einer Übertragungsleitung S1 oder S2 mit der Versorgungsspannung von z.B. + 5V.

Bei den Fehlerarten 3. und 4. ist es für eine absolut sichere Auswertung vorteilhaft, wenn trotz des Vorliegens des jeweiligen Fehlers sich noch ein Wechsel der Übertragungssignale A, /A auf der Übertragungsstrecke U ereignet. Dies ist z.B. bei Bereitstellung der binären Sendesignale SI durch einen inkrementellen Wegmeßgeber bereits dann gegeben, wenn dieser eine weitere Lageveränderung um nur ein Weginkrement signalisiert.

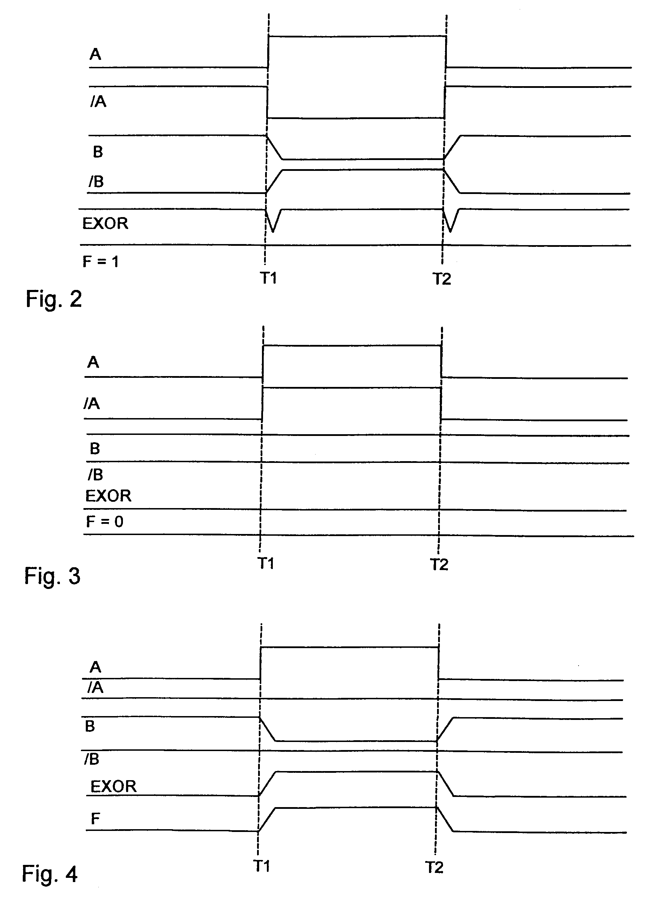

In Figur 2 ist beispielhaft der Signalverlauf in der Schaltung von Figur 1 für den ungestörten Normalbetrieb, d.h. ohne Vorliegen eines Bruches der Leitungen S1,S2 dargestellt. Im Zeitpunkt T1 ereignet sich dabei beispielhaft ein Signalpegelwechsel im Übertragungssignal A, welcher im Zeitpunkt T2 wieder verschwindet. Der Zustand des Übertragungssignales A zwischen den Zeitpunkten T1, T2 kann somit als die Übertragung eines Bits angesehen werden. Unter der Voraussetzung des ungestörten Normalbetriebs folgt das inverse Übertragungssignal /A diesem Verhalten mit umgekehrtem Vorzeichen. Diese Signalzustände bilden sich in gleicher Weise in die binären Empfangssignale B, /B ab, wobei beispielhaft die Signalpaare A,/A und B,/B zueinander komplementär sind. Am Ausgang des Exklusiv-Oder Gatters EX wird somit trotz der Signalpegelwechsel in den Signalpaaren durchgehend eine logische 1 ausgegeben, so daß das Kabelzustandssignal F mit ebenfalls logisch 1 den ungestörten Schaltungszustand signalisiert.

Aufgrund von Unsymmetrien der Optokoppler OK1, OK2 können in den Zeitpunkten T1, T2 ungleichmäßige Übergangsflanken in den Empfangssignalen B, /B auftreten, welche wiederum kurzzeitige, in Figur 2 V-förmig dargestellte, Signalpegeleinbrüche am Ausgang des Exklusiv-Oder Gatters EX (EXOR) hervorrufen. Mit Hilfe des vorteilhaften Filters FI am Ausgang der Kabelbruchüberwachung KB können diese so geglättet werden, daß das eigentliche Kabelzustandssignal F einen ungestörten, stabilen Signalpegel aufweist, in Figur 2 den logisch 1 Pegel.

In Figur 3 ist nun der Signalverlauf in der Schaltung von Figur 1 dargestellt, wenn eine der beiden Übertragungsleitungen S1 oder S2 gebrochen ist. Ereignet sich nun eine Signalwechsel auf der noch durchgehenden Leitung, z.B. ein Signalwechsel von /A zwischen den Zeitpunkten T1, T2 auf den logischen 1 Pegel, so wird trotz der Unterbrechung der anderen Leitung das komplementäre Signal mitgezogen. Im Beispiel der Figur 2 zeigt somit das Signal A nun den gleichen Verlauf wie /A. Da aber aufgrund der Unterbrechung beide Leuchtdioden L1, L2 in beiden Optokopplern OK1, OK2 an einer Elektrode nicht angeschlossen sind, leuchtet keine der beiden Leuchtdioden. Als Folge davon folgen die binären Empfangssignale B, /B dem Verlauf der Signale A, /A zwischen den Zeitpunkten T1, T2 nicht mehr, sondern verharren wie in Figur 3 dargestellt unverändert im logischen 1 Zustand. Dies bewirkt wiederum einen durchgehenden logischen 0 Pegel am Ausgang des Exklusiv-Oder Gatters EX und damit einen Fehler signalisierenden logischen 0 Zustand des Kabelzustandssignales.

In Figur 4 ist schließlich der Signalverlauf in der Schaltung von Figur 1 für den Fall dargestellt, wenn eine Übertragungsleitung, im Beispiel von Figur 4 die Leitung S2, mit dem Massepotential M in unzulässiger Weise kontaktiert ist. In diesem Fall folgt das komplementäre Übertragungssignal /A nicht mehr dem Signalpegelwechsel des Übertragungssignales A zwischen den Zeitpunkten T1, T2, sondern verharrt durchgehend auf dem logischen 0 Pegel. Entsprechend verharrt auch das dazugehörige Empfangssignal /B im ursprünglichen Signalzustand. Als Folge davon ist das Kabelzustandssignal F nicht mehr konstant, sondern wechselt den logischen Signalpegel gemeinsam mit dem Übertragungssignal F. Dieses Verhalten kann in einer angeschlossenen Steuerung zur Detektion eines unzulässigen Masseschlusses ausgewertet werden.

## Patentansprüche

1. Vorrichtung zur Detektion mechanischer Beschädigungen der beiden Leitungen (S1,S2) einer binären, symmetrischen Übertragungsstrecke (U), mit
a) einem ersten Optokoppler (OK1) am Ende der Übertragungsstrecke (U), welcher die komplementären binären Übertragungssignale (A,/A) auf den beiden Leitungen (S1,S2) in ein binäres Empfangssignal (B) umsetzt,
b) einem zweiten, relativ zum ersten Optokoppler (OK1) invers angeordneten Optokoppler (OK2) am Ende der Übertragungsstrecke (U), welcher die komplementären binären Übertragungssignale (A,/A) auf den beiden Leitungen (S1,S2) in ein inverses binäres Empfangssignal (/B) umsetzt, und mit
c) einem Exklusiv-Oder Gatter (EX), dem das binäre und das inverse binäre Empfangssignal (B,/B) zur Bildung eines den Zustand der Leitungen (S1,S2) der Übertragungsstecke (U) kennzeichnenden Signals (F) zugeführt werden.

2. Vorrichtung nach Anspruch 1, wobei dem Exklusiv-Oder Gatter (EX) ein Tiefpaßfilter (FI) nachgeschaltet ist.
